# EUROPEAN PATENT APPLICATION

(11) **EP 3 588 563 A1**
(43) Date of publication of application: **01.01.2020**
(21) Application number: 17898038.9
(22) Date of filing: 10.03.2017
(51) Int. Cl.: H01L 27/12, H01L 21/84, G02F 1/1333

(54) **ARRAY SUBSTRATE AND METHOD FOR MANUFACTURING SAME**

(30) Priority: 22.02.2017 CN 201710098323
(71) Applicant: Shenzhen China Star Optoelectronics Semiconductor Display Technology Co., Ltd., Shenzhen, Guangdong 518132 (CN)
(72) Inventor: HAO, Sikun, Shenzhen, Guangdong 518132 (CN)
(74) Representative: Patentanwälte Olbricht Buchhold Keulertz
(86) International application number: PCT/CN2017/076317
(87) International publication number: WO 2018/152874

(57) **Abstract**

An array substrate and a method for manufacturing same. The array substrate comprises a base substrate (201), a first metal layer (202), a first insulating layer (203), an active layer (204), a second metal layer (205), and a barrier layer (206), wherein the barrier layer is provided between the first insulating layer and the second metal layer and is used for increasing the distance between the first metal layer and the second metal layer at an overlapping portion between the first metal layer and the second layer and reducing the value of a parasitic capacitance formed by the first metal layer and the second metal layer.

## Description

### FIELD OF THE INVENTION

The present disclosure relates to a manufacturing field of liquid crystal display devices, and more particularly to an array substrate and a manufacturing method therefor.

### BACKGROUND OF THE INVENTION

Liquid crystal display devices are the most widely used flat display devices at the present time. They may be provided as high resolution color screens for many kinds of electronic equipment, such as mobile phones, personal digital assistant (PDA), digital cameras, computers, and laptop computers.

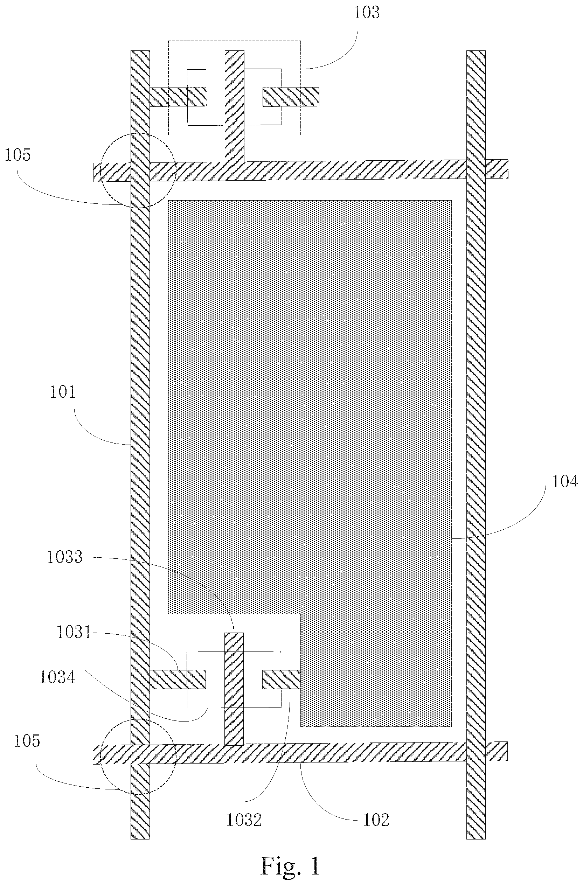

A liquid crystal display panel is the main component for the liquid crystal display device, and includes a first substrate, a second substrate, and a liquid crystal layer disposed between the two substrates, wherein the first substrate is an array substrate. Refer now to Fig. 1, which is a schematic structural top view of an array substrate of a conventional liquid crystal display panel. The array substrate includes a first metal layer, a first insulation layer, an active layer, a second metal layer, and a pixel electrode layer. The first metal layer is configured to form a scanning line 102 and a gate electrode 1033 of a thin-film transistor 103. The first insulated layer (not shown in the figure) is disposed on the first metal layer, and is configured to separate the first metal layer from the active layer. The active layer is disposed on the first insulated layer, and is configured to form an electric conduction channel 1034 of the thin-film transistor 103. The second metal layer is disposed on the active layer, and is configured to form a data line 101, a source electrode 1031 of the thin-film transistor 103, and a drain electrode 1032 of the thin-film transistor 103. The pixel electrode layer is disposed on the second metal layer, and is configured to form a pixel electrode 104, wherein the pixel electrode layer is connected to the drain electrode 1032 of the thin-film transistor 103 via a through hole.

However, because the distance between the first metal layer and the second metal layer is very short, an overlapping region 105 of the first metal layer and the second metal layer easily forms a parasitic capacitance, so that the charge rate of the pixel is lowered, and the display effect and quality of the liquid crystal display device is influenced.

Hence, it is necessary to provide an array substrate and a manufacturing method therefor, so as to solve the problems existing in the conventional technologies.

### SUMMARY OF THE INVENTION

The object of the present disclosure is to provide an array substrate and a manufacturing method therefor to solve a technical problem that: because the distance between a first metal layer and a second metal layer is very short, an overlapping region of the first metal layer and the second metal layer easily forms a parasitic capacitance, so that the charge rate of the pixel is lowered, and the display effect and quality of the liquid crystal display device is influenced.

The present disclosure provides an array substrate, which comprises:
a base substrate;
a first metal layer disposed on the base substrate, and configured to form a scanning line and a gate electrode of a thin-film transistor;
a first insulated layer disposed on the first metal layer, and configured to separate the first metal layer from an active layer;
the active layer disposed on the first insulated layer, and configured to form an electric conduction channel of the thin-film transistor;
a second metal layer disposed on the active layer, and configured to form a data line, a source electrode of the thin-film transistor, and a drain electrode of the thin-film transistor; and
a barrier layer disposed between the first insulated layer and the second metal layer, and configured to increase a distance between the first metal layer and the second metal layer in an overlapping region of the first metal layer and the second metal layer, and to lower a value of a parasitic capacitance formed between the first metal layer and the second metal layer;
wherein a projection of the overlapping region of the first metal layer and the second metal layer on the base substrate is located within a projection of the barrier layer on the base substrate; and
wherein a thickness of the barrier layer is within a range of 3-5 micrometers.

In the array substrate of the present disclosure, the projection of the overlapping region of the first metal layer and the second metal layer on the base substrate overlaps the projection of the barrier layer on the base substrate.

In the array substrate of the present disclosure, the base substrate includes a first area and a second area; and a projection of the thin-film transistor on the base substrate overlaps the first area, and a projection of the barrier layer on the base substrate overlaps the second area.

In the array substrate of the present disclosure, the barrier layer is made of an inorganic material or an organic insulated material.

The present disclosure further provides an array substrate, which comprises:
a base substrate;
a first metal layer disposed on the base substrate, and configured to form a scanning line and a gate electrode of a thin-film transistor;
a first insulated layer disposed on the first metal layer, and configured to separate the first metal layer from an active layer;
the active layer disposed on the first insulated layer, and configured to form an electric conduction channel of the thin-film transistor;
a second metal layer disposed on the active layer, and configured to form a data line, a source electrode of the thin-film transistor, and a drain electrode of the thin-film transistor; and
a barrier layer disposed between the first insulated layer and the second metal layer, and configured to increase a distance between the first metal layer and the second metal layer in an overlapping region of the first metal layer and the second metal layer, and to lower a value of a parasitic capacitance formed between the first metal layer and the second metal layer.

In the array substrate of the present disclosure, a projection of the overlapping region of the first metal layer and the second metal layer on the base substrate is located within a projection of the barrier layer on the base substrate.

In the array substrate of the present disclosure, the projection of the overlapping region of the first metal layer and the second metal layer on the base substrate overlaps the projection of the barrier layer on the base substrate.

In the array substrate of the present disclosure, the base substrate includes a first area and a second area; and a projection of the thin-film transistor on the base substrate overlaps the first area, and a projection of the barrier layer on the base substrate overlaps the second area.

In the array substrate of the present disclosure, a thickness of the barrier layer is within a range of 3-5 micrometers.

In the array substrate of the present disclosure, the barrier layer is made of an inorganic material or an organic insulated material.

According to the above-mentioned object, the present disclosure further provides a manufacturing method for an array substrate, which comprises steps of:
depositing a first metal layer on a base substrate, and forming a scanning line and a gate electrode of a thin-film transistor by a patterning process;
depositing a first insulated layer on the first metal layer;
depositing an active layer on the first insulated layer, and forming an electric conduction channel of the thin-film transistor by a patterning process;
depositing a second metal layer on the active layer, and forming a data line, a source electrode of the thin-film transistor, and a drain electrode of the thin-film transistor by a patterning process; and
forming a barrier layer between the first insulated layer and the second metal layer, so that the barrier layer increases a distance in an overlapping region between the first metal layer and the second metal layer, so as to lower a value of a parasitic capacitance formed between the first metal layer and the second metal layer.

In the manufacturing method for the array substrate of the present disclosure, a projection of the overlapping region of the first metal layer and the second metal layer on the base substrate is located within a projection of the barrier layer on the base substrate.

In the manufacturing method for the array substrate of the present disclosure, the projection of the overlapping region of the first metal layer and the second metal layer on the base substrate overlaps the projection of the barrier layer on the base substrate.

In the manufacturing method for the array substrate of the present disclosure, the base substrate includes a first area and a second area; and a projection of the thin-film transistor on the base substrate overlaps the first area, and a projection of the barrier layer on the base substrate overlaps the second area.

In the manufacturing method for the array substrate of the present disclosure, a thickness of the barrier layer is within a range of 3-5 micrometers.

In the manufacturing method for the array substrate of the present disclosure, the barrier layer is made of an inorganic material or an organic insulated material.

In the array substrate and the manufacturing method therefor according to the present disclosure, by providing the barrier layer, the distance between the first metal layer and the second metal layer in the overlapping region of the first metal layer and the second metal layer is increased, so as to lower the value of the parasitic capacitance formed between the first metal layer and the second metal layer, so that the charge rate of the pixel is increased, and the display effect and quality of a liquid crystal display device is further improved.

### DESCRIPTION OF THE DRAWINGS

For better explaining the technical solution and the effect of the present disclosure, the present disclosure will be further described in detail with the accompanying drawings and the specific embodiments.

The technical solution and the beneficial effects of the present disclosure are best understood from the following detailed description with reference to the accompanying figures and embodiments.
Fig. 1 is a schematic structural top view of an array substrate of a conventional liquid crystal display panel.
Fig. 2 is a schematic structural view of an array substrate according to a first preferable embodiment of the present disclosure.
Fig. 3 is a schematic structural view of an array substrate according to a second preferable embodiment of the present disclosure.
Fig. 4 is a schematic flowchart of a manufacturing method for an array substrate according to the present disclosure.

### DETAILED DESCRIPTION OF THE PREFERRED EMBODIMENTS

For better explaining the technical solution and the effect of the present disclosure, the present disclosure will be further described in detail with the accompanying drawings and the specific embodiments. In the drawings, units with similar structures use the same numerals. It should be note that: the object of the present disclosure is to provide a barrier layer between a first metal layer and a second metal layer, so as to increase a distance between the first metal layer and the second metal layer, and to lower a value of a parasitic capacitance formed in an overlapping region of the first metal layer and the second metal layer, so that the charge rate of the pixel is increased, and the display effect and quality of a liquid crystal display device is further improved. It is obvious that the described embodiments are just a part but not all of the embodiments of the invention. Based on the described embodiments herein, a person skilled in the art can obtain other embodiment(s), without any inventive work, which should be within the scope of the disclosure.

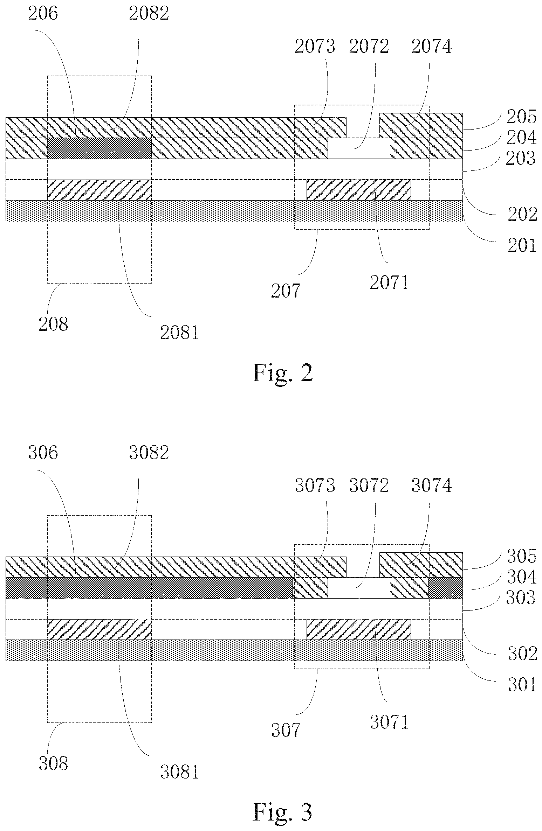

Refer now to Fig. 2, which is a schematic structural view of an array substrate according to a first preferable embodiment of the present disclosure. As shown in Fig. 2, an array substrate of the preferable embodiment includes: a base substrate 201, a first metal layer 202, a first insulation layer 203, an active layer 204, a second metal layer 205, and a barrier layer 206.

The first metal layer 202 is disposed on the base substrate 201, and is configured to form a scanning line 2081 and a gate electrode 2071 of a thin-film transistor 207. The first insulated layer 203 is disposed on the first metal layer 202, and is configured to separate the first metal layer 202 from the active layer 204. The active layer 204 is disposed on the first insulated layer 203, and is configured to form an electric conduction channel 2072 of the thin-film transistor 207. The second metal layer 205 is disposed on the active layer 204, and is configured to form a data line 2082, a source electrode 2073 of the thin-film transistor 207, and a drain electrode 2074 of the thin-film transistor 207. The barrier layer 206 is disposed between the first insulated layer 203 and the second metal layer 205, and is configured to increase a distance in an overlapping region 208 between the first metal layer 202 and the second metal layer 205, so as to lower a value of a parasitic capacitance formed between the first metal layer 202 and the second metal layer 205.

Preferably, a thickness of the barrier layer 206 of the array substrate is within a range of 3-5 micrometers; and the barrier layer 206 of the array substrate is made of an inorganic material or an organic insulated material.

Furthermore, on a projection of the overlapping region 208 of the first metal layer 202 and the second metal layer 205 on the base substrate is located within a projection of the barrier layer 206 on the base substrate 201.

Preferably, the projection of the overlapping region 208 of the first metal layer 202 and the second metal layer 205 on the base substrate 201 overlaps the projection of the barrier layer 206 on the base substrate 201.

Therefore, in the array substrate of the preferable embodiment, by providing the barrier layer 206, the distance between the first metal layer 202 and the second metal layer 205 in the overlapping region 208 of the first metal layer 202 and the second metal layer 205 is increased, so as to lower the value of the parasitic capacitance formed between the first metal layer 202 and the second metal layer 205, so that the charge rate of the pixel is increased, and the display effect and quality of a liquid crystal display device is further improved.

Refer now to Fig. 3, which is a schematic structural view of an array substrate according to a second preferable embodiment of the present disclosure. As shown in Fig. 3, an array substrate of the preferable embodiment includes: a base substrate 301, a first metal layer 302, a first insulation layer 303, an active layer 304, a second metal layer 305, and a barrier layer 306.

The first metal layer 302 is disposed on the base substrate 301, and is configured to form a scanning line 3081 and a gate electrode 3071 of a thin-film transistor 307. The first insulated layer 303 is disposed on the first metal layer 302, and is configured to separate the first metal layer 302 from the active layer 304. The active layer 304 is disposed on the first insulated layer 303, and is configured to form an electric conduction channel 3072 of the thin-film transistor 307. The second metal layer 305 is disposed on the active layer 304, and is configured to form a data line 3082, a source electrode 3073 of the thin-film transistor 307, and a drain electrode 3074 of the thin-film transistor 307. The barrier layer 306 is disposed between the first insulated layer 303 and the second metal layer 305, and is configured to increase a distance in an overlapping region 308 between the first metal layer 302 and the second metal layer 305, so as to lower a value of a parasitic capacitance formed between the first metal layer 302 and the second metal layer 305.

Preferably, a thickness of the barrier layer 306 of the array substrate is within a range of 3-5 micrometers; and the barrier layer 306 of the array substrate is made of an inorganic material or an organic insulated material.

Furthermore, a projection of the overlapping region 308 of the first metal layer 302 and the second metal layer 305 on the base substrate 301 is located within a projection of the barrier layer 306 on the base substrate 301.

Preferably, the base substrate 301 includes a first area and a second area, wherein a projection of the thin-film transistor 307 on the base substrate 301 overlaps the first area, and a projection of the barrier layer 306 on the base substrate 301 overlaps the second area.

Therefore, in the array substrate of the preferable embodiment, by providing the barrier layer 306, the distance between the first metal layer 302 and the second metal layer 305 in the overlapping region 308 of the first metal layer 302 and the second metal layer 305 is increased, so as to lower the value of the parasitic capacitance formed between the first metal layer 302 and the second metal layer 305, so that the charge rate of the pixel is increased, and the display effect and quality of a liquid crystal display device is further improved.

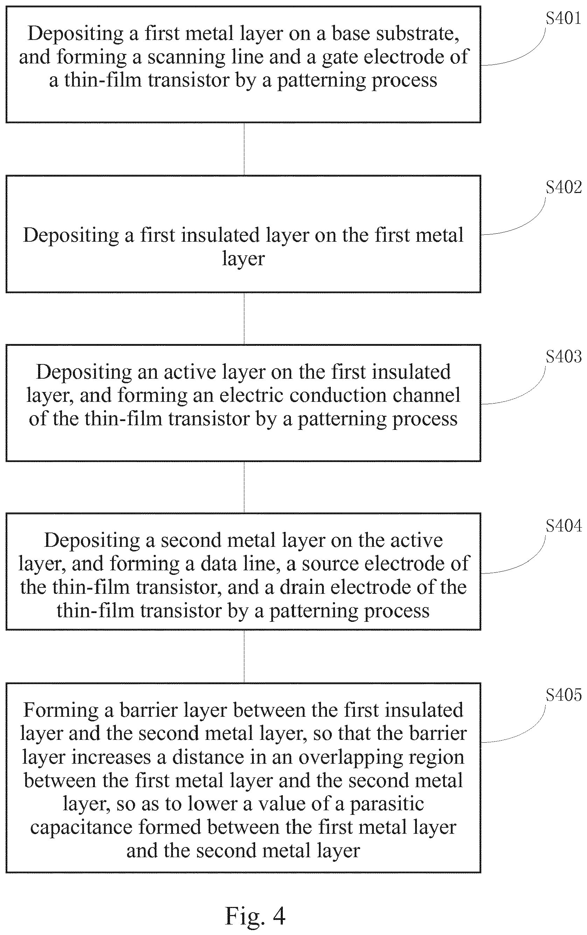

Refer now to Fig. 4, which is a schematic flowchart of a manufacturing method for an array substrate according to the present disclosure. The invention further provides the above-mentioned manufacturing method for the array substrate, which includes:
S401: depositing a first metal layer on a base substrate, and forming a scanning line and a gate electrode of a thin-film transistor by a patterning process.
S402: depositing a first insulated layer on the first metal layer.
S403: depositing an active layer on the first insulated layer, and forming an electric conduction channel of the thin-film transistor by a patterning process.
S404: depositing a second metal layer on the active layer, and forming a data line, a source electrode of the thin-film transistor, and a drain electrode of the thin-film transistor by a patterning process.
S405: forming a barrier layer between the first insulated layer and the second metal layer, so that the barrier layer increases a distance in an overlapping region between the first metal layer and the second metal layer, so as to lower a value of a parasitic capacitance formed between the first metal layer and the second metal layer.

Preferably, a projection of the overlapping region of the first metal layer and the second metal layer on the base substrate is located within a projection of the barrier layer on the base substrate.

Preferably, the projection of the overlapping region of the first metal layer and the second metal layer on the base substrate overlaps the projection of the barrier layer on the base substrate.

Preferably, the base substrate includes a first area and a second area; and a projection of the thin-film transistor on the base substrate overlaps the first area, and the projection of the barrier layer on the base substrate overlaps the second area.

In the manufacturing method for the array substrate of the preferable embodiment, by providing the barrier layer, the distance between the first metal layer and the second metal layer in the overlapping region of the first metal layer and the second metal layer is increased, so as to lower the value of the parasitic capacitance formed between the first metal layer and the second metal layer, so that the charge rate of the pixel is increased, and the display effect and quality of a liquid crystal display device is further improved.

In the array substrate and the manufacturing method therefor according to the present disclosure, by providing the barrier layer, the distance between the first metal layer and the second metal layer in the overlapping region of the first metal layer and the second metal layer is increased, so as to lower the value of the parasitic capacitance formed between the first metal layer and the second metal layer, so that the charge rate of the pixel is increased, and the display effect and quality of a liquid crystal display device is further improved.

The present disclosure has been described with preferred embodiments thereof and it is understood that many changes and modifications to the described embodiment can be carried out without departing from the scope and the spirit of the invention that is intended to be limited only by the appended claims.

## Claims

1. An array substrate, comprising:
a base substrate;
a first metal layer disposed on the base substrate, and configured to form a scanning line and a gate electrode of a thin-film transistor;
a first insulated layer disposed on the first metal layer, and configured to separate the first metal layer from an active layer;
the active layer disposed on the first insulated layer, and configured to form an electric conduction channel of the thin-film transistor;
a second metal layer disposed on the active layer, and configured to form a data line, a source electrode of the thin-film transistor, and a drain electrode of the thin-film transistor; and
a barrier layer disposed between the first insulated layer and the second metal layer, and configured to increase a distance between the first metal layer and the second metal layer in an overlapping region of the first metal layer and the second metal layer, and to lower a value of a parasitic capacitance formed between the first metal layer and the second metal layer;
wherein a projection of the overlapping region of the first metal layer and the second metal layer on the base substrate is located within a projection of the barrier layer on the base substrate; and
wherein a thickness of the barrier layer is within a range of 3-5 micrometers.

2. The array substrate according to Claim 1, wherein the projection of the overlapping region of the first metal layer and the second metal layer on the base substrate overlaps the projection of the barrier layer on the base substrate.

3. The array substrate according to Claim 1, wherein the base substrate includes a first area and a second area; and a projection of the thin-film transistor on the base substrate overlaps the first area, and the projection of the barrier layer on the base substrate overlaps the second area.

4. The array substrate according to Claim 1, wherein the barrier layer is made of an inorganic material or an organic insulated material.

5. An array substrate, comprising:
a base substrate;
a first metal layer disposed on the base substrate, and configured to form a scanning line and a gate electrode of a thin-film transistor;
a first insulated layer disposed on the first metal layer, and configured to separate the first metal layer from an active layer;
the active layer disposed on the first insulated layer, and configured to form an electric conduction channel of the thin-film transistor;
a second metal layer disposed on the active layer, and configured to form a data line, a source electrode of the thin-film transistor, and a drain electrode of the thin-film transistor; and
a barrier layer disposed between the first insulated layer and the second metal layer, and configured to increase a distance between the first metal layer and the second metal layer in an overlapping region of the first metal layer and the second metal layer, and to lower a value of a parasitic capacitance formed between the first metal layer and the second metal layer.

6. The array substrate according to Claim 5, wherein a projection of the overlapping region of the first metal layer and the second metal layer on the base substrate is located within a projection of the barrier layer on the base substrate.

7. The array substrate according to Claim 6, wherein the projection of the overlapping region of the first metal layer and the second metal layer on the base substrate overlaps the projection of the barrier layer on the base substrate.

8. The array substrate according to Claim 6, wherein the base substrate includes a first area and a second area; and a projection of the thin-film transistor on the base substrate overlaps the first area, and the projection of the barrier layer on the base substrate overlaps the second area.

9. The array substrate according to Claim 5, wherein a thickness of the barrier layer is within a range of 3-5 micrometers.

10. The array substrate according to Claim 5, wherein the barrier layer is made of an inorganic material or an organic insulated material.

11. A manufacturing method for an array substrate, comprising steps of:
depositing a first metal layer on a base substrate, and forming a scanning line and a gate electrode of a thin-film transistor by a patterning process;
depositing a first insulated layer on the first metal layer;
depositing an active layer on the first insulated layer, and forming an electric conduction channel of the thin-film transistor by a patterning process;
depositing a second metal layer on the active layer, and forming a data line, a source electrode of the thin-film transistor, and a drain electrode of the thin-film transistor by a patterning process; and
forming a barrier layer between the first insulated layer and the second metal layer, so that the barrier layer increases a distance in an overlapping region between the first metal layer and the second metal layer, so as to lower a value of a parasitic capacitance formed between the first metal layer and the second metal layer.

12. The manufacturing method for the array substrate according to Claim 11, wherein a projection of the overlapping region of the first metal layer and the second metal layer on the base substrate is located within a projection of the barrier layer on the base substrate.

13. The manufacturing method for the array substrate according to Claim 12, wherein the projection of the overlapping region of the first metal layer and the second metal layer on the base substrate overlaps the projection of the barrier layer on the base substrate.

14. The manufacturing method for the array substrate according to Claim 12, wherein the base substrate includes a first area and a second area; and a projection of the thin-film transistor on the base substrate overlaps the first area, and the projection of the barrier layer on the base substrate overlaps the second area.

15. The manufacturing method for the array substrate according to Claim 11, wherein a thickness of the barrier layer is within a range of 3-5 micrometers.

16. The manufacturing method for the array substrate according to Claim 11, wherein the barrier layer is made of an inorganic material or an organic insulated material.
